# EUROPEAN PATENT APPLICATION

(11) **EP 1 724 474 A1**
(43) Date of publication of application: **22.11.2006**
(21) Application number: 05720367.1
(22) Date of filing: 09.03.2005
(51) Int. Cl.: F16B 39/282, B65D 85/86, F16B 39/24, F16B 43/00, H01L 21/68

(54) **SUBSTRATE STORING CONTAINER**

(30) Priority: 12.03.2004 JP 2004070470
(71) Applicant: SHIN-ETSU POLYMER CO., LTD., Tokyo 103-0023 (JP)
(72) Inventor: TODA, Junya, c/o Niigata Polymer Co., Ltd., Itoigawa-shi, Niigata 9410007 (JP); NAKAYAMA, Takayuki, c/o Niigata Polymer Co., Ltd., Itoigawa-shi, Niigata 9410007 (JP)
(74) Representative: Felder, Peter
(86) International application number: PCT/JP2005/004095
(87) International publication number: WO 2005/088142

(57) **Abstract**

A substrate storage container is provided which can convey, fix and store substrates safely, with threaded members not being loosened by a load applied to a mounting member of the substrate storage container when the container storing substrates is conveyed or when the container is fixed to a substrate processing apparatus and by a heating process at the time of washing and drying of the container. For fastening the mounting member (6), such as a side plate for conveyance, a bottom plate for positioning the container with respect to a substrate processing apparatus, etc., to the substrate storage container including a container body (1) and a lid (2) by threaded members (3), a locking means for preventing loosening of the threaded members (3) is interposed between engagement surfaces of each threaded member (3) and the mounting member (6).

## Description

### TECHNICAL FIELD

The present invention relates generally to a substrate storage container that stores substrates, such as semiconductor wafers made of silicon, mask glass plates made of glass, etc., for transport between plants and for conveyance or storage in process steps, and more particularly, to a substrate storage container with a locking means of a mounting member attached to the substrate storage container.

### BACKGROUND ART

In recent years, miniaturization of semiconductor components and reduction in wiring pitch have been increasingly progressing. A substrate storage container is fabricated to have a high sealing property and is handled in an automated manner to eliminate contamination due to human activity so as not to contaminate stored substrates.
In response to such a tendency of the industry, a substrate storage container disclosed in Japanese Patent Application Laid-Open Publication No. 2000-306988 has been proposed, which stores semiconductor wafers inside for conveyance and storage in a production plant of semi-conductor components.

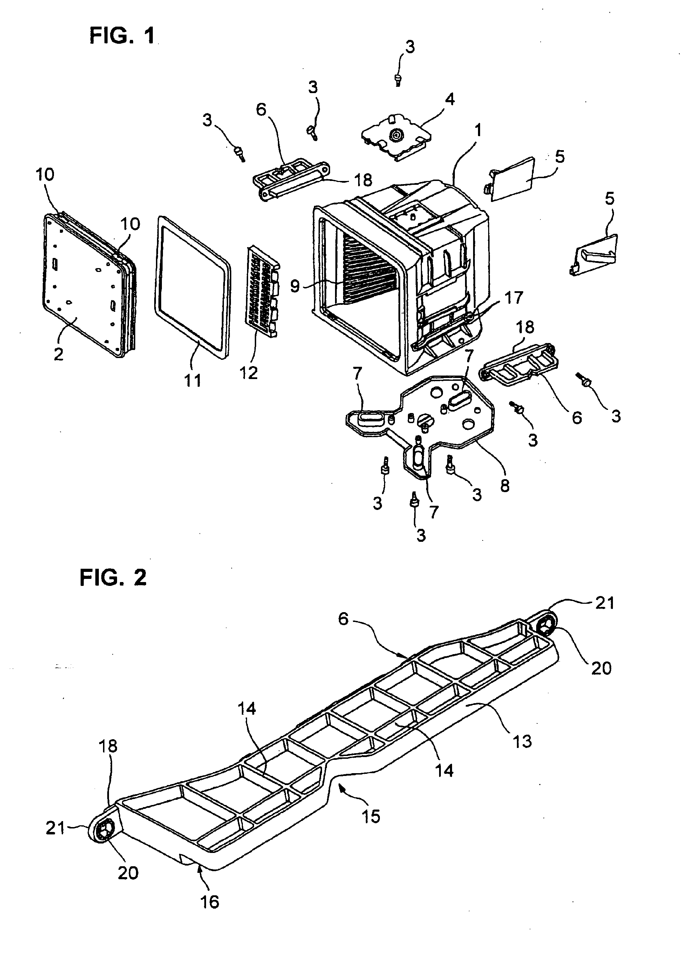

As shown in Fig. 1, such a substrate storage container is basically constituted by a container body 1 provided with an opening at the front thereof and including support portions 9 provided on opposed side wall surfaces thereof to support a plurality of substrates at certain intervals within the container, a lid 2 that closes the opening, and a seal member 11 interposed between the container body 1 and the lid 2.
A top surface of the container body 1 has attached thereto a robotic flange 4 for overhead conveyance of the substrate storage container, and opposite outer side walls of the container body 1 have attached thereto a pair of manual handles 5 necessary for conveyance of the substrate storage container, a pair of side rails 6, etc., using threaded members 3. On a bottom surface of the container body 1, a bottom plate 8 is attached to a fixing portion (not shown) provided on the bottom of the container body 1 by the threaded members 3, which bottom plate 8 includes positioning members 7 for positioning and fixing the substrate storage container precisely to a substrate processing apparatus.

The plant in which the substrate storage containers are used employs a mini-environment production system and includes a highly cleaned interior space demarcated from the exterior space, wherein a plurality of substrate processing apparatuses are disposed in the interior space to perform various processes with respect to the substrates.

The substrate storage container is docked with such a substrate processing apparatus through positioning members 7, and thereafter an opening/closing operation is performed with latch mechanisms 10 disposed within the lid 2 to remove the lid 2 from the container body 1. Thus, a substrate is taken out from the opening and is supplied to the substrate processing apparatus. After the process is completed, the substrate is inserted into the substrate storage container again, and the lid 2 is mounted to the container body 1, followed by locking with the latch mechanisms 10 to close the opening. Then, the substrate storage container is automatically conveyed to the next process step. By repeating such operations, a semiconductor chip is formed on the surface of the substrate.

### DISCLOSURE OF THE INVENTION

### PROBLEM TO BE SOLVED BY THE INVENTION

At each time of automated conveyance as described above, the substrate storage container is conveyed to the next process step while the automatic conveyance apparatus grips, supports and fixes the mounting members for conveyance, which are attached to the substrate storage container, to thereby perform processing.
Since the number of steps reaches 600 in production of semiconductor components, the conveyance frequency of the substrate storage container is increased considerably. Since such conveyance is performed at high speed to increase the number of cycles and a weight of the container storing substrates is as heavy as about 8 kg, a remarkable load is applied to the mounting members for conveyance at each time of conveyance.

In order to maintain cleanliness in the container, a washing process is performed periodically for the substrate storage container, and after water drops adhering to the substrate storage container are removed thoroughly in a subsequent drying step, the substrate storage container is reused.
At the drying step, since the substrate storage container is dried and processed at a high temperature of about 90°C, the container itself is expanded and contracted by heating and the threaded members 3 fixing the mounting members to the substrate storage container may loosen.

The present invention has been made to solve the above problems. Accordingly, an object of the present invention is to provide a substrate storage container which can convey, fix and store substrates safely, and which ensures threaded members fixing a mounting member are not loosened by a load applied to the mounting member of the substrate storage container and by a heating process at the time of washing and drying the substrate storage container when the substrate storage container stores and conveys the substrate and when the substrate storage container is fixed to the substrate processing apparatus.

### MEANS FOR SOLVING PROBLEM

According to the present invention, a substrate storage container comprises a container body, a lid, a mounting member attached to the container body or the lid, and a threaded member fixing the mounting member to the container body or the lid, the mounting member and the threaded member including respective surfaces cooperating with each other when the mounting member is fixed to the container body or the lid by the threaded member, and the substrate storage container is characterized in that: a locking means for preventing loosening of the threaded member is interposed between said surfaces of the threaded member and the mounting member.

The locking means preferably includes a projection provided on one of said surfaces of the threaded member and the mounting member and a recess provided on the other one of said surfaces so as to engage with the projection.

The locking means may include a washer interposed between said surfaces of the mounting member and the threaded member, wherein the washer includes contact surfaces each being in contact with a respective one of said surfaces of the mounting member and the threaded member, and wherein the washer is provided on at least one of the contact surfaces thereof with a protrusion engaging with the recess provided on the other one of said surfaces of the threaded member and the mounting member.

The recess may include inner side surfaces formed asymmetrically relative to a rotation direction of the threaded member, wherein one of the inner side surfaces abuts against the projection provided on the one of said surfaces of the threaded member and the mounting member or abuts against the protrusion of the washer in the case of the rotation of the threaded member in a loosening direction, to thereby prevent the rotation of the threaded member.

In this case, both of the inner side surfaces of the recess are preferably formed as inclined surfaces and the inclination of the one inner side surface is preferably greater than the inclination of the other inner side surface. In this case, the inclination of the one inner side surface is preferably 70° to 90° and the inclination of the other inner side surface is preferably 10° to 30°.

The washer may be provided on the other contact surface thereof with a second recess or second protrusion engaging with the projection provided on the one of said surfaces of the threaded member and the mounting member.

The protrusion of the washer is preferably formed to be a semicircular shape in cross section, wherein one of the inner side surfaces of the recess is formed as a circular arc surface having a cross-sectional shape which meshes with the semicircular cross section of the protrusion, and the other of the inner side surfaces is formed as a gently inclined surface.

Preferably, when an initial torque is measured by fastening the threaded member to the container body or the lid with a predetermined torque and measuring a torque at the time of loosening the threaded member and when a torque is measured at the time of loosening the threaded member after performing 50 times a heat cycle constituted of: maintaining the substrate storage container at a normal temperature of 20°C for 20 minutes; increasing the temperature to 100°C in 40 minutes; maintaining the temperature at 100°C for 30 minutes; and gradually reducing the temperature to the normal temperature in 50 minutes, a ratio of the difference between the initial torque and the torque after the heat cycles to the initial torque is within ±20% of the initial torque.

### EFFECT OF THE INVENTION

The substrate storage container of the present invention can convey, fix and store substrates safely since a locking means is arranged on the threaded member used for fixing to the substrate storage container a mounting member such as a side plate for conveyance or a bottom plate for positioning to the substrate process apparatus, and the threaded member is not loosened by a load applied to the mounting member of the substrate storage container each time the stored substrate is conveyed and fixed to a substrate processing apparatus and by a heating process at the time of washing and drying the substrate storage container.

### BRIEF DESCRIPTION OF DRAWINGS

Fig. 1 is an exploded perspective view showing one embodiment of a substrate storage container according to the present invention.
Fig. 2 is a perspective view showing an example of a side rail in the one embodiment of the present invention.
Fig. 3 is a side view of the side rail of Fig. 2.
Fig. 4 is a partially enlarged perspective view showing a portion of the side rail of Fig. 2 to be fixed to a container body.
Fig. 5 is a front view of an example of a threaded member used in the one embodiment of the present invention.
Fig. 6 is a plan view of the threaded member of Fig. 5.
Fig. 7 is an explanatory view illustrating an attached state of a mounting member by the use of the threaded member in the one embodiment of the present invention.
Fig. 8 is a plan view of a washer used in another embodiment of the present invention.
Fig. 9 is a cross-sectional view of the washer, the view being taking along line IX-IX of Fig. 8.
Fig. 10 is a bottom view of the washer of Fig. 8.
Fig. 11 is a plan view of another example of the washer used in another embodiment of the present invention.
Fig. 12 is a cross-sectional view of the washer, the view being taken along line XII-XII of Fig. 11.
Fig. 13 is a bottom view of the washer of Fig. 11.
Fig. 14 is an explanatory view illustrating an attached state of the mounting member by the use of the threaded member in a further embodiment of the present invention.
Fig. 15 is a time schedule of a temperature condition of a heat cycle test performed in examples.

### BEST MODE FOR CARRYING OUT THE INVENTION

Fig. 1 is an exploded perspective view showing an embodiment of a substrate storage container according to the present invention.
As shown in Fig. 1, a substrate storage container of the present invention is constituted by a container body 1 that stores substrates, a lid 2 and a plurality of mounting members attached thereto.
More particularly, the container body 1 is provided on a top surface thereof with a robotic flange 4 that is adapted to be gripped by a ceiling conveyance apparatus called OHT (Overhead Hoist Transportation) for conveying the substrate storage container. The container body 1 is provided on opposite outer side walls thereof with respective side rails 6, 6 and respective manual handles 5, 5 that are projected for conveyance with an AGV (Automated Guided Vehicle). The container body 1 is also provided with a bottom plate 8 attached to a bottom surface thereof and including positioning members 7 having a V-shaped groove which are disposed at three positions so as to position the container body 1 with respect to a substrate processing apparatus.

The lid 2 has a pair of latch mechanisms 10 built in that permit an automatic opening/closing operation thereof from the outside and a seal member 11 attached around a peripheral edge of a side wall thereof. A retainer 12 including engagement grooves for holding the substrates is attached to a surface of the lid 2 opposed to an opening of the container body 1. Threaded members 3 are used to attach mounting members such as the robotic flange 4, the manual handles 5, 5, the side rails 6, 6, and the bottom plate 8. In the present invention, the mounting members are attached to the substrate storage container while a locking means is disposed between each threaded member 3 and the mounting member.

The embodiment of the present invention will hereinafter be described taking the side rail 6 as an example of the mounting member attached to the container body 1.
Fig. 2 is a perspective view showing an example of the side rail including a side wall conforming to the wall shape of the container body, although the shape thereof is somewhat different from that of the side rails shown in Fig. 1. The side rail 6 includes a flat base and a peripheral wall 13 disposed around the base and is partitioned into substantially rectangular shapes by a plurality of ribs 14 located in a reticular pattern to reinforce a flat portion of the base. The peripheral wall 13 is provided on one surface thereof with a V-shaped concave portion 15 used for positioning with respect to a conveyance apparatus.

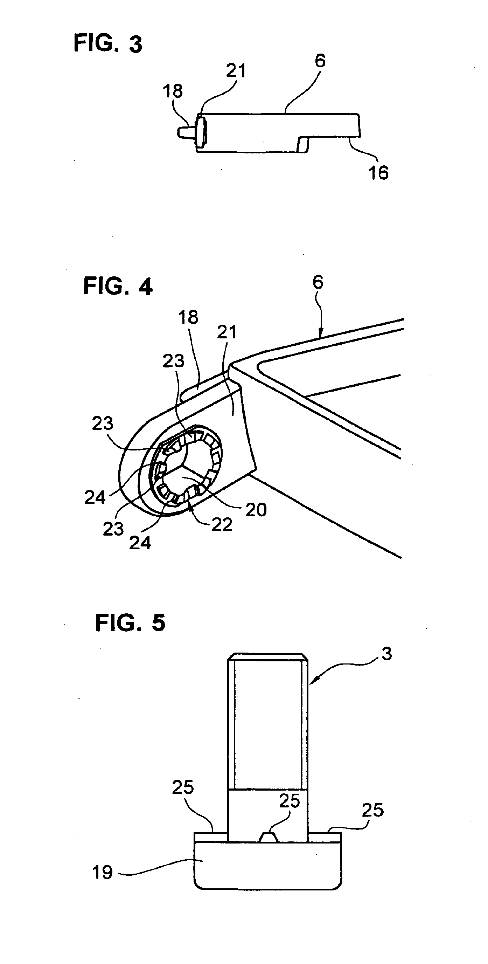

As shown in Fig. 3, a stepped portion 16 including a flat surface is disposed on the under side of the base of the side rail 6. The flat surface of the step portion 16 is formed to be even so that it can be brought into contact with two horizontal claws disposed on the conveyance apparatus to lift the substrate storage container.

A linear insertion protrusion 18 is disposed integrally on a part of the side wall opposite from the stepped portion 16 and is formed so as to be held, without play, between a pair of fixed ribs 17 and 17 (Fig. 1) formed on each of the right and left side walls of the container body 1.
The side rail 6 is provided on each of both ends thereof with a fixing portion 21 having a through-hole 20 so as to attach and fix the side rail 6 to the side wall of the container body 1. The threaded members (or male screws) 3 are inserted through the respective through-holes 20 and threaded (screwed) into other threaded members (or female screws, not shown) provided on the container body 1, to thereby fasten the side rail 6 to the container body 1.

In the present invention, as shown in Fig. 4, a rugged portion 22 is formed as a locking means on a circumferential edge portion of the fixing portion 21 of the side rail 6 around the through-hole 20, which edge portion comes into contact with the threaded member 3. The rugged portion 22 includes recesses and projections that are formed alternately in the circumferential direction so that the recesses are adapted to be engaged with a plurality of ribs 25 provided on a surface of the threaded member 3 which comes into contact with the circumferential edge portion around the through-hole 20 and the projections include inclined surfaces that guide the ribs 25 of the threaded member 3.

With regard to the inclined surfaces formed on the sides of each projection, one is formed to be a gently inclined surface 23 in association with a fastening direction of the threaded member 3 and formed at an angle of, for example, about 20° relative to a plane parallel to a flat surface of the fixing portion 21, while the other is formed to be a steeply inclined surface 24 in association with a loosening direction of the threaded member 3 and formed at an inclination angle greater than that of the gently inclined surface 23, for example, about 87°. The gently inclined surface 23 is formed at the inclination angle within a range of 10° to 30°, and preferably, a range of 15° to 25°; the steeply inclined surface 24 is formed at the inclination angle within a range of 70° to 90°, and preferably, a range of 80° to 88°; and it is desirable that the gently inclined surface 23 and the steeply inclined surface 24 be formed to be asymmetric shapes. As can be clearly seen from Fig. 4, the opposing side surfaces of the adjacent projections are the inner side surfaces of one recess.

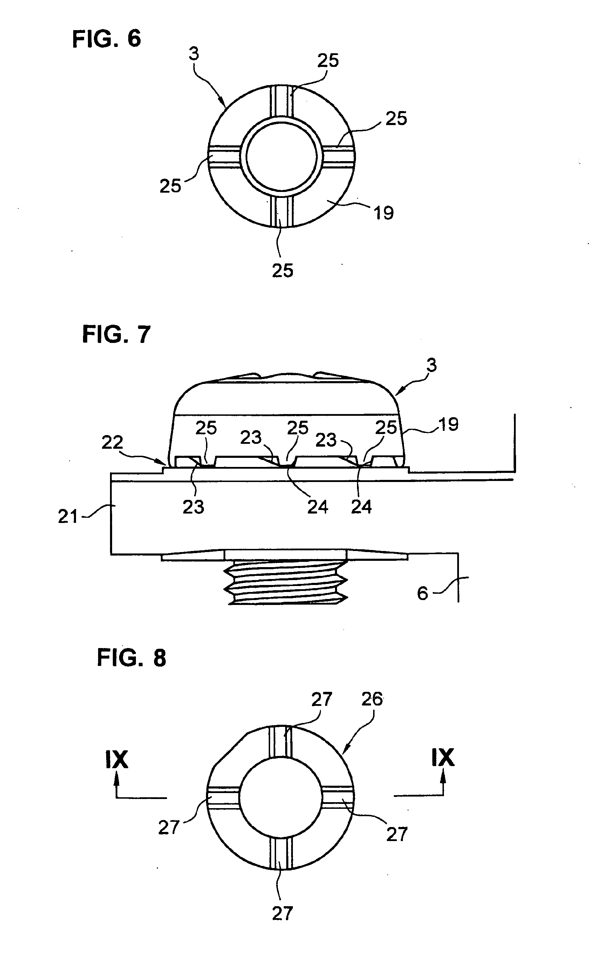

As shown in Figs. 5 and 6, the threaded member 3 includes a plurality of protruded ribs 25 formed on the under side of a head 19 to be extended outward from the center thereof. The height of the ribs 25 is preferably within a range of 1/2 to 3/4 of the pitch of the thread of the threaded member 3. In the case of the threaded member 3 being, for example, an M5 screw according to JIS, since the pitch thereof is 0.8 mm, the height of the ribs 25 may be set to 0.5 mm, which is greater than a half of the pitch. The ribs 25 may be formed to have a cross-sectional shape of a trapezoid, rectangle, circle or the like, which conforms to the shape of the recesses of the rugged portion 22 provided on the fixing portion 21 of the side rail 6.

Fig. 7 is a partial explanatory view showing the case in which the side rail 6 is fixed to the container body 1 by the use of such threaded members 3. The ribs 25 of the threaded member 3 and the rugged portion 22 provided on the fixing portion 21 of the side rail 6 are engaged with and fixed to each other. In this instance, the side surfaces of the ribs 25 of the threaded member 3 are formed at the same inclination angle as that of the steeply inclined surfaces 24 of the rugged portion 22 of the fixing portion 21 so as to provide surface contact, with the result that the threaded member 3 is more firmly fixed and the loosening of the threaded member 3 can be prevented.

The threaded member 3 is made of an appropriate material, which preferably is a material with fewer eluted ions and less emission of volatile gas so as not to contaminate the substrates received in the substrate storage container, as well as with sufficient rigidity, impact strength and heat-resistant strength. For example, the material includes resin material which exhibits excellent mechanical strength, such as poly(ether ether ketone), poly(ether imide), poly(ether sulfone), poly(phenyl sulfone), polyamide, etc., and above all, it is particularly preferred that the threaded member be made of poly(ether ether ketone).

It is more preferable to use a washer for the locking means. Figs. 8 to 10 show an example of a washer in another embodiment of the present invention, wherein the mounting member, i.e., the side rail 6 is fixed to the container body 1 by the use of the washer between the threaded member 3 and the mounting member. Even when the washer is used, the aforementioned side rail 6 and threaded member 3 can be used without modification.

The washer 26 is provided on one surface thereof with a plurality of linear protruded ribs 27 with a trapezoidal cross-sectional shape, which extend from the center of washer 26 toward outside as is the case with the ribs provided on the threaded member 3. The protruded ribs 27 are located to engage with the rugged portion 22 provided on the fixing portion 21 of the side rail 6. The other surface of the washer 26 is provided with notches 28 mating with the respective ribs 25 of the threaded member 3.

When such a washer 26 is used, since the washer 26 is deformed and firmly fixed by the ribs 25 of the threaded member 3 through fastening of the threaded member 3, the ribs 27 of the washer 26 engage with the rugged portion 22 of fixing portion 21 of the side rail 6, and the ribs 25 of the threaded member 3 engage with the respective notches 28 of the washer 26, resulting in the loosening of the threaded member 3 being effectively prevented.
The washer 26 is preferably used which is made of polycarbonate resin with excellent mechanical strength and elasticity, and which can be deformed by the ribs 25 of the threaded member 3. Further, the washer 26 may be made of polypropylene resin, polycarbonate resin containing carbon fibers, or the like. The washer may also be made of resin material with excellent mechanical strength, such as poly(ether ether ketone), poly(ether imide), poly(ether sulfone), poly(phenyl sulfone), polyamide, etc., in addition to polycarbonate and polypropylene.

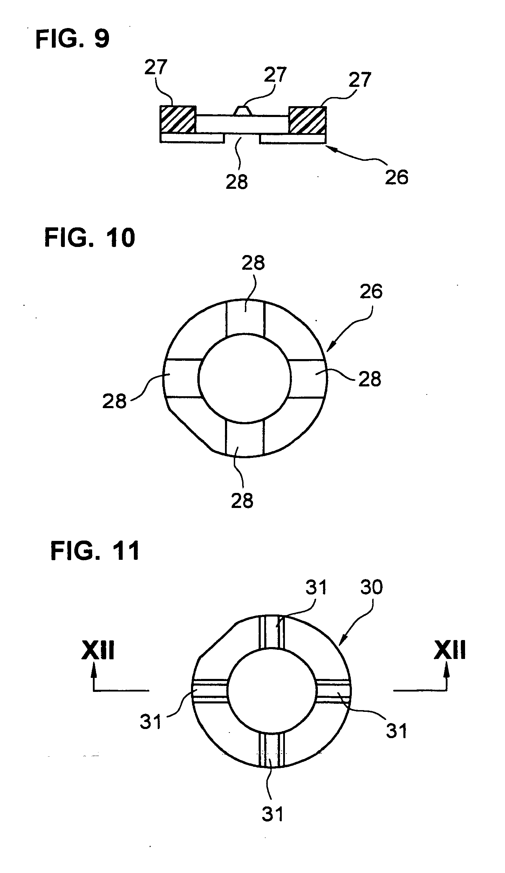

Figs. 11 to 13 show another example of a washer used in the substrate storage container according to the present invention. When this type of washer is used, the aforementioned side rail 6 and threaded member 3 can also be used without modification. The washer 30 is provided on both front and rear surfaces thereof with pluralities of ribs 31 and 32, respectively, which are similar to the ribs provided on the threaded member 3. The ribs 31 and 32 are located to engage with the rugged portion 22 provided on the fixing portion 21 of the side rail 6 and the ribs 25 of the threaded member 3, respectively, so that the loosening of the threaded member 3 can be prevented more effectively.

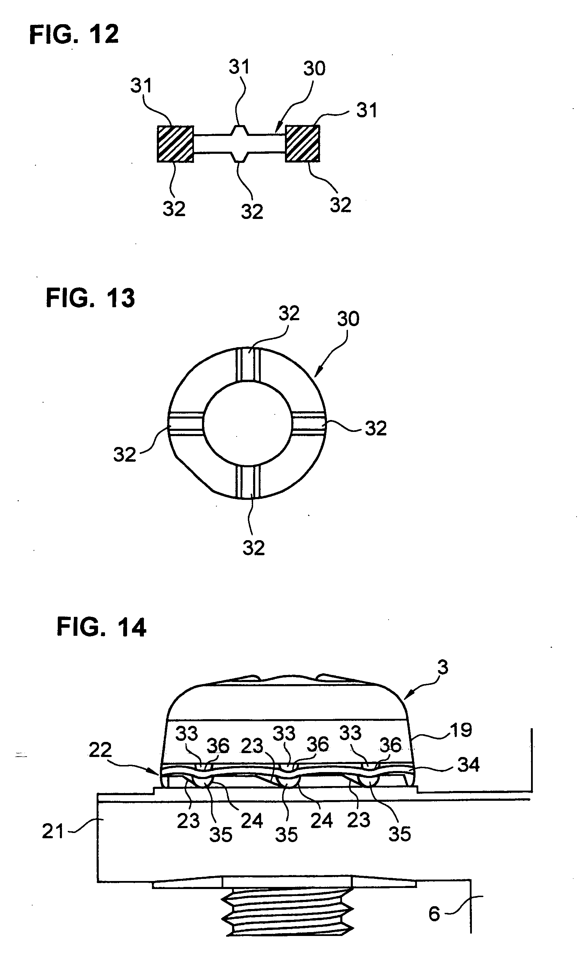

In an embodiment shown in Fig. 14, when the side rail 6 is fixed to the container body 1 by the threaded members 3, ribs 33 of the threaded members 3 and ribs 35 provided on at least one surface of a washer 34 are each formed as a strip-like protrusion with a semicircular shape in cross section. The washer 34 is provided on the other surface thereof with concave portions 36 corresponding to the ribs 33 of the threaded members 3. In addition, the steeply inclined surfaces 24 of the recesses of the rugged portion 22 provided on the fixing portion 21 of the side rail 6 are each formed to have a partial circle or circular arc shape in cross section.

The ribs 33 and 35 with a semicircular shape in cross section facilitate the engagement or mating of the threaded member 3 with the mounting member and the engagement or mating of the mounting member with the washer during fastening of the threaded member 3. The steeply inclined surfaces 24 are each formed on the rugged portion 22 of the fixing portion 21 of the side rail 6 in association with the loosening direction of the threaded member 3, to thereby effectively prevent the loosening of the threaded members 3. The cross section of the steeply inclined surfaces is not limited to a circular arc shape and may be a triangular shape or rectangular shape.

Such fixation of the mounting member to the substrate storage container with the threaded members can be applied not only to the attachment of the side rail but also to the attachment of the robotic flange 4 and the bottom plate 8, fixation of other mounting members, or the attachment and fixation of a plate to the lid, as described above.

### Example 1

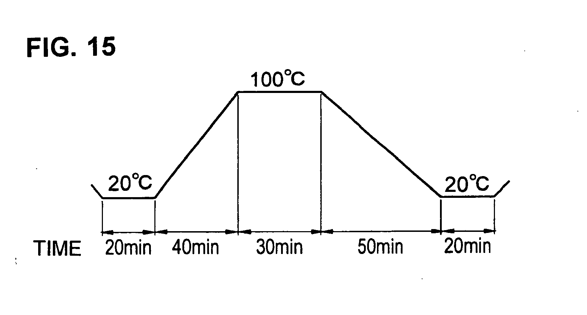

A side rail provided with rugged portions on fixing portions as shown in Fig. 2 and male screws made of poly(ether ether ketone) resin each having a diameter of 5 mm and having ribs formed on a head thereof as shown in Fig. 5 were used. The male screws were each threaded into a female screw formed in a container body made of polycarbonate resin and were each fastened with a predetermined torque (0.5 N·m) to fix the fixing portion of the side rail to the container body; and when the screw was loosened, a torque was measured as an initial torque. A heat cycle test of 50 cycles was performed for the side rail which had been fixed to the container body by fastening the male screws with the predetermined torque again, and then a torque was measured when the male screw was loosened and compared with the initial torque value. The torque was measured with an electric screwdriver that could output or display a torque. The temperature condition of the heat cycle test was changed as shown in Fig. 15. More specifically, after being maintained at a normal temperature of 20°C for 20 minutes, the temperature was increased to 100°C in 40 minutes, was maintained at 100°C for 30 minutes, and then was gradually decreased to the normal temperature in 50 minutes. Such a cycle of heating and cooling was repeated 50 times.

### Example 2

Washers made of polycarbonate resin shown in Fig. 8 were used in combination with the same side rail, male screws, and container body as those in example 1 to fix the fixing portions of the side rail in a manner similar to that in example 1, and thus the heat cycle test of the side rail was performed.
For the purpose of comparison, the same heat cycle test as in examples 1 and 2 was performed using male screws without any rib on a head thereof and a side rail with no rugged portion on the fixing portion thereof, wherein the male screws and the side rail had the same sizes and were made of the same materials as those in examples 1 and 2, and then torques were measured when the male screws were each loosened before and after the heat cycle test. The test results of examples 1 and 2 and the comparative example are shown in Table 1.

**Table 1**

| | Example 1 | Example 2 | Comparative Example |
|---|---|---|---|
| Presence of Ribs on Threaded Member | Yes | Yes | No |
| Presence of Washer | No | Yes | No |
| Presence of Protrusions on Washer | - | Yes | - |
| Rugged Portion on Fixing Portion | Yes | Yes | No |
| Initial Torque (N·m) | 0.47 | 0.49 | 0.45 |
| Torque after Heat Cycles (N·m) | 0.51 | 0.53 | 0.35 |

As is apparent from the results of Table 1, when the mounting member is fixed to the substrate storage container with the locking means of the present invention interposed between the contact surfaces of the threaded member and the mounting member, mounting portions hardly loosen and the change rate of the torque relative to the initial torque ((initial torque - torque after heat cycles)/initial torque) is within ±10%. In contrast, in the case of the comparative example without using the locking means, the change rate of the torque exceeds 20%, and thus there is a problem in that the screw may loosen during use. Therefore, it is understood that the present invention can provide the substrate storage container that can offer stable storage performance for a long period of time.

### INDUSTRIAL APPLICABILITY

The present invention can be applied not only to a substrate storage container for semiconductor wafers, etc., but also to storage containers in various fields, to which mounting members are fixed and attached by threaded members.

## Claims

1. A substrate storage container comprising a container body, a lid, a mounting member attached to the container body or the lid, and a threaded member fixing the mounting member to the container body or the lid, the mounting member and the threaded member including respective surfaces cooperating with each other when the mounting member is fixed to the container body or the lid by the threaded member,
**characterized in that**:
a locking means for preventing loosening of the threaded member is interposed between said surfaces of the threaded member and the mounting member.

2. The substrate storage container according to claim 1, wherein the locking means includes a projection provided on one of said surfaces of the threaded member and the mounting member and a recess provided on the other one of said surfaces so as to engage with the projection.

3. The substrate storage container according to claim 1, wherein the locking means includes a projection provided on one of said surfaces of the threaded member and the mounting member and a recess provided on the other one of said surfaces,
wherein the locking means includes a washer interposed between said surfaces of the mounting member and the threaded member, wherein the washer includes contact surfaces each being in contact with a respective one of said surfaces of the mounting member and the threaded member, and wherein the washer is provided on at least one of the contact surfaces thereof with a protrusion engaging with the recess provided on the other one of said surfaces of the threaded member and the mounting member.

4. The substrate storage container according to claim 2, wherein the recess includes inner side surfaces formed asymmetrically relative to a rotation direction of the threaded member, and wherein one of the inner side surfaces abuts against the projection in the case of the rotation of the threaded member in a loosening direction, to thereby prevent the rotation of the threaded member.

5. The substrate storage container according to claim 3, wherein the recess includes inner side surfaces formed asymmetrically relative to a rotation direction of the threaded member, and wherein one of the inner side surfaces abuts against the protrusion of the washer in the case of the rotation of the threaded member in a loosening direction, to thereby prevent the rotation of the threaded member.

6. The substrate storage container according to claim 4, wherein both of the inner side surfaces of the recess are formed as inclined surfaces, and wherein the inclination of the one inner side surface is greater than that of the other inner side surface.

7. The substrate storage container according to claim 5, wherein both of the inner side surfaces of the recess are formed as inclined surfaces, and wherein the inclination of the one inner side surface is greater than that of the other inner side surface.

8. The substrate storage container according to claim 3, 5 or 7, wherein the washer is provided on the other contact surface thereof with a second recess engaging with the projection provided on the one of said surfaces of the threaded member and the mounting member.

9. The substrate storage container according to claim 3, 5 or 7, wherein the washer is provided on the other contact surface thereof with a second protrusion engaging with the projection provided on the one of said surfaces of the threaded member and the mounting member.

10. The substrate storage container according to claim 5 or 7, wherein the protrusion of the washer is formed to be a semicircular shape in cross section, wherein one of the inner side surfaces of the recess is formed as a circular arc surface having a cross-sectional shape which meshes with the semicircular cross section of the protrusion, and the other of the inner side surfaces is formed as a gently inclined surface.

11. The substrate storage container according to claim 6, wherein the inclination of the one inner side surface is 70° to 90° and the inclination of the other inner side surface is 10° to 30°.

12. The substrate storage container according to claim 7, wherein the inclination of the one inner side surface is 70° to 90° and the inclination of the other inner side surface is 10° to 30°.

13. The substrate storage container according to claim 1, wherein when an initial torque is measured by fastening the threaded member to the container body or the lid with a predetermined torque and measuring a torque at the time of loosening the threaded member and when a torque is measured at the time of loosening the threaded member after performing 50 times a heat cycle constituted of: maintaining the substrate storage container at a normal temperature of 20°C for 20 minutes; increasing the temperature to 100°C in 40 minutes; maintaining the temperature at 100°C for 30 minutes; and gradually reducing the temperature to the normal temperature in 50 minutes, a ratio of the difference between the initial torque and the torque after the heat cycles to the initial torque is within ±20% of the initial torque.
